# EUROPEAN PATENT SPECIFICATION

(11) **EP 2 403 077 B1**
(45) Date of publication and mention of the grant of the patent: **22.11.2017**
(21) Application number: 10290361.4
(22) Date of filing: 30.06.2010
(51) Int. Cl.: H01S 5/026, H01S 5/20, H01S 5/22, H01S 5/227, G02B 6/12

(54) **A photonic device and a method of manufacturing a photonic device**
Photonische Vorrichtung und Verfahren zur Herstellung einer photonischen Vorrichtung
Dispositif photonique et procédé de fabrication d'un dispositif photonique

(43) Date of publication of application: 04.01.2012
(73) Proprietor: ALCATEL LUCENT, 92100 Boulogne-Billancourt (FR)
(72) Inventor: Jany, Christophe, 91460 Marcoussis (FR); Alexandre, François, 91460 Marcoussis (FR)
(74) Representative: Shamsaei Far, Hassan

(56) References cited:
- US-A1- 2007 183 738
- HIDEAKI TANAKA ET AL: "5-GB/S PERFORMANCE OF INTEGRATED LIGHT SOURCE CONSISTING OF LAMBDA/4-SHIFTED DFB LASER AND EA MODULATOR WITH SI INP BH STRUCTURE", JOURNAL OF LIGHTWAVE TECHNOLOGY, IEEE SERVICE CENTER, NEW YORK, NY, US, vol. 8, no. 9, 1 September 1990 (1990-09-01), pages 1357-1362, XP000174424, ISSN: 0733-8724, DOI: DOI:10.1109/50.59165
- TANAKA H ET AL: "OPTICAL SHORT PULSE GENERATION AND DATA MODULATION BY A SINGLE-CHIP INGAASP TANDEM-INTEGRATED ELECTROABSORPTION MODULATOR (TEAM)", ELECTRONICS LETTERS, IEE STEVENAGE, GB, vol. 29, no. 11, 27 May 1993 (1993-05-27), pages 1002-1004, XP000372924, ISSN: 0013-5194

## Description

The present invention relates to photonic devices comprising at least one active component and at least one passive component coupled together.

One means here by "active component" a component, possibly of the optoelectronic type, which requires energy to operate (voltage or current). So, it may be a laser (or active lasing medium), or a modulator, or a photodetector or an amplifier, possibly of the SOA type ("semiconductor optical amplifier"), or a variable optical attenuator (or VOA), or else a phase shifter, for instance.

Moreover one means here by "passive component" a component which does not produce energy or which is incapable of power gain. So, it may be a waveguide, an arrayed waveguide grating (AWG), an optical MMI (MultiMode Interference) structure, or a filter, for instance.

It has been proposed to produce photonic devices, such as photonic integrated circuits (or PIC), in order to offer on the same device at least one optical active functionality, such as laser emission, optical modulation, amplification or photodetection, and at least one passive functionality, such as passive waveguiding (for instance for optical signal routing between active components).

The integration of active and passive components (that are each offering a functionality) is generally obtained by a hybrid solution such as butt-joint of discrete components and/or active semiconductor components with passive waveguides (Si/SiO2 type, for instance). The production of this type of hybrid solution appears to be complex because it requires a very precise positioning of the components and the use of spot size converters (or mode adaptator). Moreover this type of solution shows limitations such as coupling losses between active and passive components and an important assembly cost.

To avoid complex optical interconnection between components, a monolithic approach can be based on semiconductor (III-V type) ridge technologies for both active and passive components. These technologies, called Ridge or BRS ("Buried Ridge Stripe"), and which may be mixed, are generally based on definition of semiconductor heterojunctions, i.e. a waveguide core sandwiched between N-type and P-type doped semiconductor layers.

Unfortunately, the Ridge technology induces a deformation of the optical modes due to a bad optical confinement, and the BRS technology induces bad electrical properties. Moreover these technologies induce optical losses by absorption.

Various techniques can be used to reduce these optical losses, and notably the so-called Selective Area Growth (or SAG). But, if these techniques allow to reduce effectively the optical losses resulting from absorption in the waveguide core, they do not have any effect on the main optical losses resulting from absorption due to P-type doped semiconductor that is set on the waveguide core.

Devices comprising monolithically integrated active and passive components and having a semi-insulating burying layer are known from for example US2007/0183738 A1 or H. Tanaka et al., J. of Lightwave Technology 8 (1990) 1357.

So the object of this invention is to improve the situation to allow production of photonic devices having reduced coupling losses and/or optical losses resulting from absorption.

The object of the present invention is fulfilled by a device and a method of its production according to independent claims 1,7. Preferred embodiments are defined in the dependent claims.

Accordingly some embodiments feature a photonic device, characterized in that it comprises a structure having, a doped semiconductor substrate, at least one active component and at least one passive component coupled to the at least one active component, said active component being laterally buried by means of a semi-insulating semiconductor and vertically buried by means of a doped semiconductor cladding layer, thereby forming a heterojunction structure, and said passive component being laterally and vertically buried by means of said semi-insulating semiconductor, and said active component being monolithically integrated onto said doped semiconductor substrate.

According to some specific embodiments said active component is monolithically integrated onto said semi-insulating semiconductor.

According to some specific embodiments each active component is a semi-insulating buried heterostructure.

According to some specific embodiments the device comprises a substrate made of Indium Phosphide doped semiconductor or Gallium Arsenide doped semiconductor or Gallium Nitride doped semiconductor.

According to some specific embodiments said semiconductor substrate is N-doped, and said semiconductor cladding layer is highly P-doped.

According to some specific embodiments the device comprises at least one integrated active component chosen from a group comprising at least a laser, an optical modulator, a photodetector and an amplifier.

Some embodiments feature a method of manufacturing a photonic device , characterized in that it comprises the steps of:
- growing an intrinsic layer thereby producing a waveguide on said doped semiconductor substrate, and a doped semiconductor layer on said intrinsic layer, to produce a vertical structure,
- depositing a dielectric mask on top of said doped semiconductor layer in designated areas where one or more active and one or more passive components are intended to be produced,
- etching said vertical structure in each of said areas to produce first and second etched vertical structures, intended for constituting respectively said active component(s) and passive component(s) on remaining parts of said doped semiconductor substrate,
- removing selectively said mask on top of each second etched vertical structure,
- growing said semi-insulating semiconductor on said doped semiconductor substrate around the lateral sides of each first etched vertical structure and all around each second etched vertical structure,
- removing selectively said mask on top of each first etched vertical structure,
- growing said doped semiconductor cladding layer on said semi-insulating semiconductor and on top of each first etched vertical structure.

According to some specific said vertical structure is etched over a first depth in at least one area of an active component and over a second depth, smaller than said first depth, in at least one area of a passive component.

According to some specific embodiments in the case where at least two active components are produced and are coupled through a passive component, said doped semiconductor cladding layer set on top of the semi-insulating semiconductor of this passive component is selectively etched.

According to some specific embodiments an etching technique chosen from a group comprising at least reactive ion etching, ion beam etching, inductive coupled plasma etching and dry etching is used..

Other features and advantages of the invention will become apparent on examining the detailed specifications hereafter and the appended drawings, wherein:
- figure 1 schematically illustrates a top view of an example of embodiment of a device, after implementation of first and second steps of an example of method according to the invention
- figures 2A and 2B schematically illustrate cross section views respectively along lines IIa-IIa and IIb-IIb of the device of figure 1,
- figure 3 schematically illustrates a top view of the device after implementation of third and fourth steps of the example of method according to the invention,
- figures 4A and 4B schematically illustrate cross section views respectively along lines IVa-IVa and IVb-IVb of the device of figure 3,
- figure 5 schematically illustrates a top view of the device after implementation of a fifth step of the example of method according to the invention,
- figures 6A and 6B schematically illustrate cross section views respectively along lines VIa-VIa and Vlb-Vlb of the device of figure 5,
- figure 7 schematically illustrates a top view of the device after implementation of sixth and seventh steps of the example of method according to the invention,
- figures 8A and 8B schematically illustrate cross section views respectively along lines VIIIa-VIIIa and VIIIb-VIIIb of the device of figure 7,
- figure 9 schematically illustrates a top view of the device after implementation of an optional eighth step of the example of method according to the invention,
- figures 10 and 11 schematically illustrate cross section views respectively of the first active component AC1 and the passive component when different etching depths are carried out during the third step of the example of method according to the invention.

The appended drawings may serve not only to complete the invention, but also to contribute to its definition, if need be.

The invention aims at providing a method which is intended for producing photonic devices PD having reduced coupling losses and/or optical losses resulting from absorption, and comprising at least one active component ACi and at least one passive component PC coupled therebetween.

The method according to the invention relates to producing, on a doped semiconductor substrate DSS and by monolithic integration, at least one active component ACi and at least one passive component PC coupled together.

For instance, the doped semiconductor substrate DSS is made of N-doped Indium Phosphide (InP-N). But, other types of material based on semiconductors may be used, and notably InP-P doped with Zn or semi-insulating InP doped with Fe or Ru.

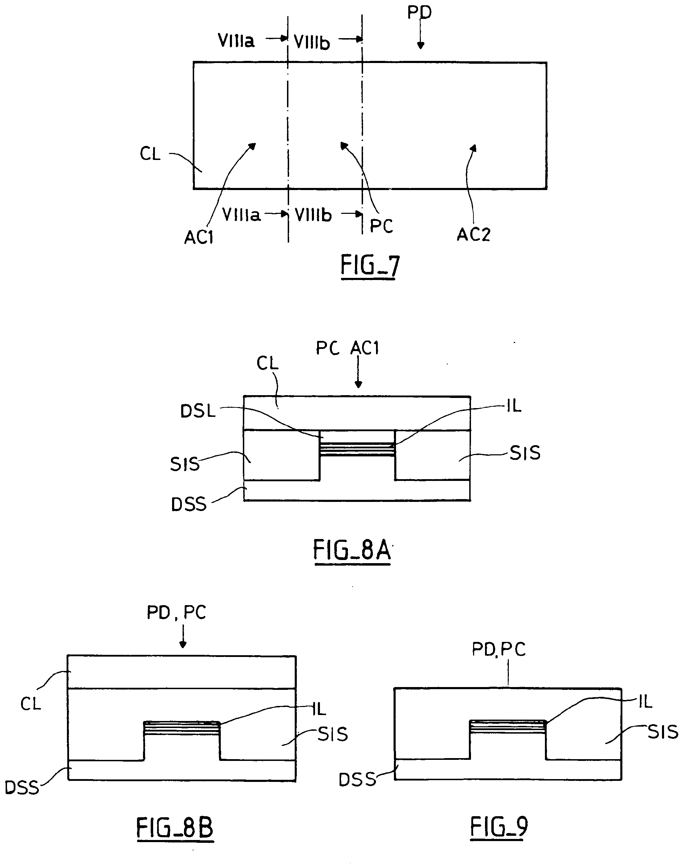

According to the invention (and as illustrated in figures 7 and 8A), each active component ACi is laterally buried by means of a semi-insulating semiconductor SIS and vertically buried by means of a doped semiconductor cladding layer CL, in order to have a heterojunction (or diode) structure. Moreover, still according to the invention (and as illustrated in figures 7 and 8B), each passive component PC is laterally and vertically buried by means of the semi-insulating semiconductor SIS.

In the following description, it will be considered, as example, that the method is implemented in order to produce two active components ACi (i = 1 or 2) connected through a passive component PC on a doped semiconductor substrate DSS, and therefore to produce a three component photonic device PD, such as the one illustrated in figures 7, 8A and 8B.

For instance, the photonic device PD illustrated in figures 7, 8A and 8B comprises a first active component AC1 which constitutes a laser (or active lasing medium), a passive component PC which constitutes a waveguide, and a second active component AC2 which constitutes a modulator. But, the invention is not limited to the production of this type of photonic device PD. Indeed, it may comprise one active component coupled to at least one integrated passive component, or two or more active components coupled therebetween through integrated passive components. So, a photonic device PD according to the invention may comprise a laser and/or a modulator and/or a photodetector and/or an amplifier, possibly of the SOA type ("semiconductor optical amplifier"), for instance, and at least one waveguide and/or a filter and/or a multiplexer and/or a demultiplexer and/or an optical coupler and/or an arrayed waveguide grating (or AWG) and/or an optical MMI (MultiMode Interference) structure, for instance.

In the following description, it will be considered, as example, that each active component ACi is a semi-insulating buried heterostructure (or SIBH). But, this is not mandatory.

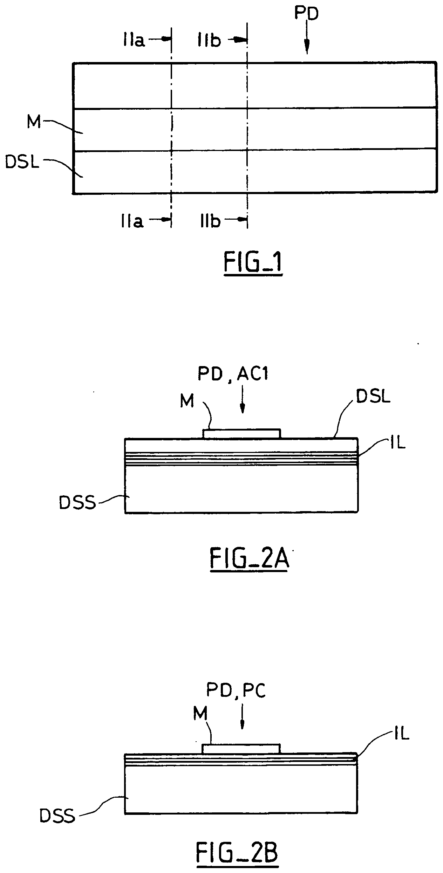

A detailed, but not limiting, example of the method according to the invention is described hereafter with reference to figures 1-11.

This example of method comprises at least seven steps.

A first step comprises growing an intrinsic layer IL defining a waveguide on the doped semiconductor substrate DSS, and then a doped semiconductor layer DSL on this intrinsic layer IL, in order to define a vertical structure.

This first step can be done by means of an epitaxy.

In the case where the doped semiconductor substrate DSS is N-doped, it participates to the vertical structure, and the doped semiconductor layer DSL of the latter is P-doped. For instance, if the semiconductor substrate DSS is made of N-doped InP (InP-N, doped with Si or S, for instance), the intrinsic layer IL can be made of quaternary semiconductors (such as GalnAsP (Gallium Indium Arsenide Phosphide)) or of quantum wells (for instance made of sub-layers of Aluminium or Phosphorus), and the doped semiconductor layer DSL can be made of P-doped InP (InP-P, doped with Zn or Be, for instance).

But other combinations of layers and/or material, known by a person skilled in the art, could be used, notably to define other type of components.

A second step comprises depositing a dielectric mask M on top of the doped semiconductor layer DSL in as many chosen area as active ACi and passive PC components to be produced.

For instance, the dielectric mask M can be made by a photoresist layer or a SiO₂ layer or else a Si₃N₄ layer.

The result of the implementation of the first an second steps is illustrated in figures 1, 2A and 2B.

A third step comprises etching the vertical structure (produced in the first step) in each of its component areas (i.e. on each lateral side of each dielectric mask M) in order to produce first VS1i and second VS2 etched vertical structures that are intended to constitute respectively the active component(s) ACi and passive component(s) PC on remaining parts of the doped semiconductor substrate DSS.

This third step can be done by means of an etching technique such as the reactive ion etching (or RIE). But other etching techniques may be used, and notably the ion beam etching (or IBE), the inductive coupled plasma etching (or ICPE) and the dry etching.

A fourth step comprises removing selectively the dielectric mask M on top of each second etched vertical structure VS2.

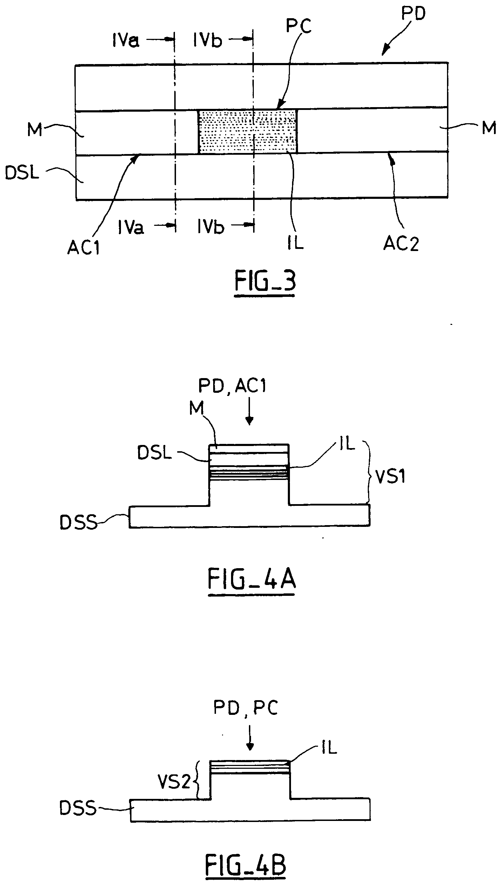

The result of the implementation of the third and fourth steps is illustrated in figures 3, 4A and 4B.

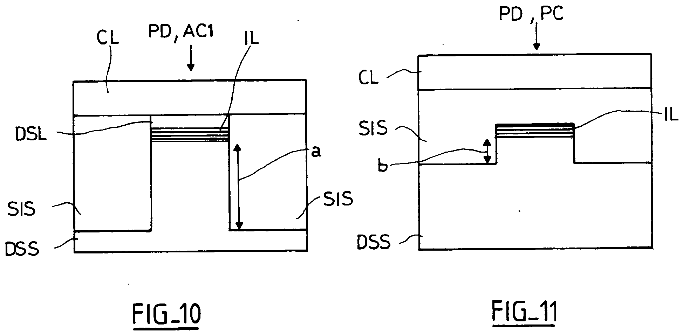

In the example illustrated in figures 4 to 8, the vertical structure has been etched over a depth which is the same whatever the active CAi and passive PC components. But this is not mandatory. Indeed, and as illustrated in the examples of figures 9 and 10, it is possible to selectively etch the vertical structure over a first depth a in at least one area of an active component ACi and over a second depth b, which is smaller than the first depth a, in at least one area of a passive component PC. An explanation for such a depth difference will be given below.

A fifth step comprises growing a semi-insulating semiconductor SIS on the doped semiconductor substrate DSS around the lateral sides of each first etched vertical structure VS1i and all around each second etched vertical structure VS2 (i.e. around its lateral sides and on top of it).

This fifth step can be done by means of an epitaxy.

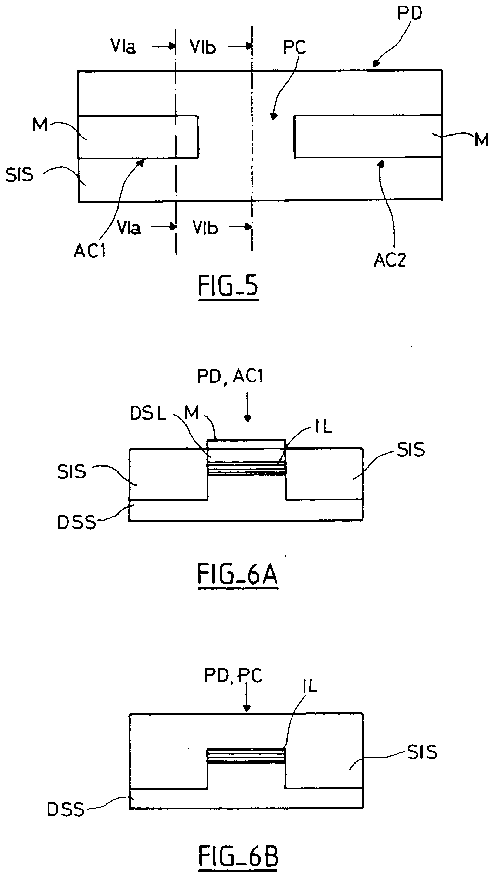

The result of the implementation of this fifth step is illustrated in figures 5, 6A and 6B.

A sixth step comprises removing selectively the dielectric mask M on top of each first etched vertical structure VS1 i.

A seventh step comprises growing a doped semiconductor cladding layer DCL on the semi-insulating semiconductor SIS and on top of each first etched vertical structure VS1i.

This seventh step can be done by means of an etching technique such as the reactive ion etching (or RIE). But other etching techniques may be used, and notably the ion beam etching (or IBE), the inductive coupled plasma etching (or ICPE) and the dry etching.

For instance, if the doped semiconductor layer DSL is made of P-doped InP (InP-P), the doped semiconductor cladding layer DCL can be also made of P-doped InP (InP-P) or of highly P-doped InP (InP-P+). An opposite structure of the NIP type could also be used instead of a structure of the PIN type, if the semiconductor substrate DSS is P-doped instead of N-doped.

The result of the implementation of the sixth and seventh steps is illustrated in figures 7, 8A and 8B.

For instance, the control electrode may be deposited onto the component during the step that occurs before the last one, while the ground electrode may be deposited on the back face of the doped semiconductor substrate DSS during the last step.

As mentioned before and as illustrated in figures 10 and 11, it is possible to selectively etch the vertical structure over first a and second b depths, with a > b, respectively in areas of active component(s) ACi and passive component(s) PC. Indeed, this allows to bury a passive component PC in a larger semi-insulating semiconductor SIS and therefore to avoid optical propagation into the doped semiconductor cladding layer CL.

As illustrated in figures 1-8B, in the case where the photonic device must comprise at least two active components ACi coupled through a passive component PC, it may be advantageous to proceed to an eighth step consisting in selectively etching the doped semiconductor cladding layer CL that is set on top of the semi-insulating semiconductor SIS of this passive component PC. Indeed, with this last (optional) etching step there is no more P-type doped semiconductor on the waveguide core IL of the passive component PC, and therefore there is no more optical loss resulting from absorption due to this P-type doped semiconductor. So, the considered passive component PC appears to be electrically insulated. Moreover when such an electrical insulation is implemented between two active components ACi, it further allows to ensure an electrical insulation between these two active components ACi. This is of real interest because this avoids having to carry out a costly proton implantation between every two etched vertical structures VS1i and VS2.

The result of the implementation of this last etching is illustrated in figure 9.

The invention offers several advantages amongst which:
- low optical losses, due to the fact that the passive components are fully buried in a semi-insulating semiconductor,
- reduced coupling losses due to full integration of the passive components, such as waveguides, that are used to route the optical signals between active components and optical fibres,
- preservation of the circular optical wave form all along the photonic device, and therefore reduced optical losses and improved optical fibre coupling, due to the uniform optical confinement (both vertical and lateral) that is induced into the active and passive components by the use of the SIBH technology,
- possibility to give any orientation (from 0° to 180°) to the passive components due to the particularity of semi-insulating semiconductor growth step on passive area without dielectric mask. So any kind of passive waveguide design could be defined as it is the case in the arrayed waveguide gratings (AWGs).

## Claims

1. A photonic device (PD), comprising a structure having, a doped semiconductor substrate (DSS), at least one active component (ACi) and at least one passive component (PC) optically coupled to the at least one active component, an intrinsic layer as a waveguide is comprised by the active and the passive component, said active component (ACi) being laterally directly buried by means of a semi-insulating semiconductor (SIS) and vertically directly buried by means of a doped semiconductor cladding layer (CL), thereby forming a heterojunction structure, and said passive component (PC) being laterally and vertically directly buried by means of said semi-insulating semiconductor (SIS), and said active component and said passive component being monolithically integrated onto said doped semiconductor substrate (SIS).

2. A device according to claim 1, **characterized in that** said active component and said passive component are monolithically integrated onto said semi-insulating semiconductor

3. A device according to claim 1, **characterized in that** each active component (ACi) is a semi-insulating buried heterostructure.

4. A device according to any one of claims 1 and 2, **characterized in that** the device comprises a substrate made of Indium Phosphide doped semiconductor (DSS) or Gallium Arsenide doped semi-conductor or Gallium Nitride doped semiconductor.

5. A device according to claim 3, **characterized in that** said semiconductor substrate (DSS) is N-doped, and said semiconductor cladding layer (CL) is highly P-doped.

6. A device according to any one of the previous claims, **characterized in that** it comprises at least one integrated active component (ACi) chosen from a group comprising at least a laser, an optical modulator, a photodetector and an amplifier.

7. A method of manufacturing a photonic device, comprising the steps of:
- growing an intrinsic layer (IL) thereby producing a waveguide on a doped semiconductor substrate (DSS), and a doped semiconductor layer (DCL) on said intrinsic layer (IL), to produce a vertical structure,
- depositing a dielectric mask on top of said doped semiconductor layer (DSL) in designated areas where one or more active (ACi) and one or more passive (PC) components are intended to be produced,
- etching said vertical structure in each of said areas to produce first (VS1i) and second (VS2) etched vertical structures, intended for constituting respectively said active component(s) (ACi) and passive component(s) (PC) on remaining parts of said doped semiconductor substrate (DSS),
- removing selectively said mask on top of each second etched vertical structure (VS2),
- growing a semi-insulating semiconductor (SIS) on said doped semiconductor substrate (DSS) directly around the lateral sides of each first etched vertical structure (VS1i) and directly all around each second etched vertical structure (VS2),
- removing selectively said mask on top of each first etched vertical structure (VS 1i),
- growing a doped semiconductor cladding layer (CL) on said semi-insulating semiconductor (SIS) and on top of each first etched vertical structure (VS1i).

8. A method according to claim 7, **characterized in that** said vertical structure is etched over a first depth in at least one area of an active component (ACi) and over a second depth, smaller than said first depth, in at least one area of a passive component (PC).

9. A method according to any one of claims 7 and 8, **characterized in that**, in the case where at least two active components (ACi) are produced and are coupled through a passive component (PC), said doped semiconductor cladding layer (CL) set on top of the semi-insulating semiconductor (SIS) of this passive component (PC) is selectively etched.

10. A method according to one of claims 7 to 9, **characterized in that** an etching technique chosen from a group comprising at least reactive ion etching, ion beam etching, inductive coupled plasma etching and dry etching is used.

## Patentansprüche

1. Photonische Vorrichtung (PD), umfassend eine Struktur mit einem dotierten Halbleitersubstrat (DSS) mit mindestens einer aktiven Komponente (ACi) und mindestens einer passiven Komponente (PC), optisch an die mindestens eine aktive Komponente gekoppelt, eine eigenleitende Schicht als ein Wellenleiter, die von der aktiven und passiven Komponente umfasst wird, wobei besagte aktive Komponente (ACi) seitlich direkt erdverlegt wird mittels eines halbisolierenden Halbleiters (SIS) und vertikal direkt erdverlegt wird mittels einer dotierten Halbleiter-Umhüllungsschicht (CL), sodass eine Heteroübergangs-Struktur gebildet wird, und wobei besagte passive Komponente (PC) lateral und vertikal direkt erdverlegt wird mittels besagtem halbisolierenden Halbleiter (SIS), und wobei besagte aktive Komponente und besagte passive Komponente monolithisch auf besagtem dotierten Halbleitersubstrat (SIS) integriert sind.

2. Vorrichtung nach Anspruch 1, **dadurch gekennzeichnet, dass** besagte aktive Komponente und besagte passive Komponente monolithisch auf besagtem halbisolierenden Halbleiter integriert sind.

3. Vorrichtung nach Anspruch 1, **dadurch gekennzeichnet, dass** jede aktive Komponente (ACi) eine halbisolierende erdverlegte Heterostruktur ist.

4. Vorrichtung nach einem der Ansprüche 1 und 2, **dadurch gekennzeichnet, dass** die Vorrichtung ein Substrat umfasst, das aus einem dotierten Halbleiter aus Indiumphosphid (DSS) oder aus einem dotierten Halbleiter aus Galliumarsenid oder aus einem dotierten Halbleiter aus Galliumnitrid besteht.

5. Vorrichtung nach Anspruch 3, **dadurch gekennzeichnet, dass** besagtes Halbleiter-Substrat (DSS) N-dotiert ist und besagte Halbleiter-Umhüllungsschicht (CL) hoch P-dotiert ist.

6. Vorrichtung nach einem beliebigen der vorstehenden Ansprüche, **dadurch gekennzeichnet, dass** sie mindestens eine integrierte aktive Komponente (ACi) umfasst, gewählt aus einer Gruppe, die mindestens einen Laser, einen optischen Modulator, einen Photodetektor und einen Verstärker umfasst.

7. Verfahren zum Herstellen einer photonischen Vorrichtung, umfassend die Schritte:
- Züchten einer eigenleitenden Schicht (IL), wodurch ein Wellenleiter auf einem dotierten Halbleitersubstrat (DSS) hergestellt wird, und einer dotierten Halbleiterschicht (DSL) auf besagter eigenleitender Schicht (IL) zum Herstellen einer vertikalen Struktur,
- Aufbringen einer dielektrischen Maske oben auf besagter dotierter Halbleiterschicht (DSL) in den vorgesehenen Bereichen, wobei ein oder mehrere aktive (ACi) und ein oder mehrere passive (PC) Komponenten hergestellt werden sollen,
- Ätzen besagter vertikaler Struktur in jeden der besagten Bereiche zur Herstellung von ersten (VS1i) und zweiten (VS2) geätzten vertikalen Strukturen, die jeweils besagte aktive Komponenten (ACi) und passive Komponenten (PC) auf verbleibenden Teilen des besagten dotierten Halbleitersubstrats (DSS) bilden sollen,
- selektives Entfernen besagter Maske oben auf jeder zweiten geätzten vertikalen Struktur (VS2),
- Züchten eines halbisolierenden Halbleiters (SIS) auf besagtem dotierten Halbleitersubstrat (DSS) direkt um die lateralen Seiten jeder ersten geätzten vertikalen Struktur (VS1i) und direkt um jede zweite geätzte vertikale Struktur (VS2),
- selektives Entfernen besagter Maske oben auf jeder ersten geätzten vertikalen Struktur (VS1 i),
- Züchten einer dotierten Halbleiter-Umhüllungsschicht (CL) auf besagtem halbisolierenden Halbleiter (SIS) und oben auf jeder ersten geätzten vertikalen Struktur (VS1 i).

8. Verfahren nach Anspruch 7, **dadurch gekennzeichnet, dass** besagte vertikale Struktur über eine erste Tiefe in mindestens einen Bereich einer aktiven Komponente (ACi) geätzt wird und über eine zweite Tiefe, die geringer ist als die erste Tiefe, in mindestens einen Bereich einer passiven Komponente (PC).

9. Verfahren nach einem der Ansprüche 7 und 8, **dadurch gekennzeichnet, dass**, falls mindestens zwei aktive Komponenten (ACi) hergestellt und durch eine passive Komponente (PC) gekoppelt werden, besagte dotierte Halbleiter-Umhüllungsschicht (CL) oben auf dem halbisolierenden Halbleiter (SIS) von dieser passiven Komponente (PC) selektiv geätzt wird.

10. Verfahren nach einem der Ansprüche 7 bis 9, **dadurch gekennzeichnet, dass** eine Ätztechnik, gewählt aus einer Gruppe umfassend mindestens reaktives lonenätzen, lonenstrahlätzen, induktiv gekoppeltes Plasmaätzen und Trockenätzen, verwendet wird.

## Revendications

1. Dispositif photonique (PD), comprenant une structure ayant, un substrat semi-conducteur dopé (DSS), au moins un composant actif (ACi) et au moins un composant passif (PC) couplé optiquement à l'au moins un composant actif, une couche intrinsèque comme guide d'ondes est incluse dans les composants actif et passif, ledit composant actif (ACi) étant directement enfoui latéralement au moyen d'un semi-conducteur semi-isolant (SIS) et directement enfoui verticalement au moyen d'une couche de placage en semi-conducteur dopée (CL), formant ainsi une structure à hétérojonction, et ledit composant passif (PC) étant directement enfoui latéralement et verticalement au moyen dudit semi-conducteur semi-isolant (SIS), et ledit composant actif et ledit composant passif étant intégrés monolithiquement sur ledit substrat semi-conducteur dopé (SIS).

2. Dispositif selon la revendication 1, **caractérisé en ce que** ledit composant actif et ledit composant passif sont intégrés monolithiquement sur ledit semi-conducteur semi-isolant.

3. Dispositif selon la revendication 1, **caractérisé en ce que** chaque composant actif (ACi) est une hétérostructure enterrée semi-isolante.

4. Dispositif selon l'une quelconque des revendications 1 et 2, **caractérisé en ce que** le dispositif comprend un substrat constitué d'un semi-conducteur dopé au phosphure d'indium (DSS) ou d'un semi-conducteur dopé à l'arséniure de gallium ou d'un semi-conducteur dopé au nitrure de gallium.

5. Dispositif selon la revendication 3, **caractérisé en ce que** ledit substrat semi-conducteur (DSS) est dopé N, et ladite couche de placage en semi-conducteur (CL) est hautement dopée P.

6. Dispositif selon l'une quelconque des revendications précédentes, **caractérisé en ce qu'**il comprend au moins un composant actif intégré (ACi) choisi dans un groupe comprenant au moins un laser, un modulateur optique, un photodétecteur et un amplificateur.

7. Procédé de fabrication d'un dispositif photonique, comprenant les étapes suivantes :
- faire croître une couche intrinsèque (IL) produisant ainsi un guide d'ondes sur un substrat semi-conducteur dopé (DSS), et une couche semi-conductrice dopée (DSL) sur ladite couche intrinsèque (IL), pour produire une structure verticale,
- déposer un masque diélectrique au-dessus de ladite couche semi-conductrice dopée (DSL) dans des zones désignées où un ou plusieurs composants actifs (ACi) et un ou plusieurs composants passifs (PC) sont censés être produits,
- graver ladite structure verticale dans chacune desdites zones pour produire une première structure verticale gravée (VS1i) et une deuxième structure verticale gravée (VS2), destinées à constituer respectivement ledit/lesdits composant(s) actif(s) (ACi) et composant(s) passif(s) (PC) sur des parties restantes dudit substrat semi-conducteur dopé (DSS),
- retirer sélectivement ledit masque au-dessus de chaque deuxième structure verticale gravée (VS2),
- faire croître un semi-conducteur semi-isolant (SIS) sur ledit substrat semi-conducteur dopé (DSS) directement autour des côtés latéraux de chaque première structure verticale gravée (VS1i) et directement tout autour de chaque deuxième structure verticale gravée (VS2),
- retirer sélectivement ledit masque au-dessus de chaque première structure verticale gravée (VS1 i),
- faire croître une couche de placage en semi-conducteur dopée (CL) sur ledit semi-conducteur semi-isolant (SIS) et au-dessus de chaque première structure verticale gravée (VS1 i).

8. Procédé selon la revendication 7, **caractérisé en ce que** ladite structure verticale est gravée sur une première profondeur dans au moins une zone d'un composant actif (ACi) et sur une deuxième profondeur, inférieure à ladite première profondeur, dans au moins une zone d'un composant passif (PC).

9. Procédé selon l'une quelconque des revendications 7 et 8, **caractérisé en ce que**, dans le cas où au moins deux composants actifs (ACi) sont produits et sont couplés par un composant passif (PC), ladite couche de placage en semi-conducteur dopée (CL) placée au-dessus du semi-conducteur semi-isolant (SIS) de ce composant passif (PC) est gravée sélectivement.

10. Procédé selon l'une des revendications 7 à 9, **caractérisé en ce qu'**une technique de gravure, choisie dans un groupe comprenant au moins la gravure ionique réactive, la gravure par faisceau d'ions, la *gravure au plasma couplé* par induction et la gravure à sec, est utilisée.
